# EUROPEAN PATENT APPLICATION

(11) **EP 2 065 923 A2**
(43) Date of publication of application: **03.06.2009**
(21) Application number: 08168215.5
(22) Date of filing: 03.11.2008
(51) Int. Cl.: H01L 21/3213

(54) **Methods for adjusting critical dimension uniformity in an etch process**

(30) Priority: 28.11.2007 US 946562
(71) Applicant: Applied Materials, Inc., Santa Clara, CA 95054 (US)
(72) Inventor: Ding, Guowen, San Jose, CA 95131 (US); Lee, Changhun, San Jose, CA 95120 (US); Su, Teh-Tien, Milpitas, CA 95035 (US)
(74) Representative: Zimmermann & Partner

(57) **Abstract**

Methods for etching a metal material layer disposed on a substrate to form features with desired profile and uniform critical dimension (CD) of the features across the substrate. In one embodiment, a method for etching a material layer disposed on a substrate includes providing a substrate having a metal layer disposed on a substrate into an etch reactor, flowing a gas mixture containing at least a chlorine containing gas and a passivation gas into the reactor, the passivation gas including a nitrogen gas and an unsaturated hydrocarbon gas, wherein the nitrogen gas and the unsaturated hydrocarbon gas has a gas flow rate ratio between about 1:3 and about 20:1, and etching the metal layer using a plasma formed from the gas mixture.

## Description

Embodiments of the present invention generally relate to semiconductor processing technologies and, more specifically, to methods for etching a metal layer disposed on a substrate, in particular to form an interconnection structure. Even more specifically, some embodiments relate to methods for etching features in a material layer in an interconnect structure with desired profile and critical dimension (CD).

Reliably producing sub-half micron and smaller features is one of the key technologies for the next generation of very large scale integration (VLSI) and ultra large-scale integration (ULSI) of semiconductor devices. However, as the limits of circuit technology are pushed, the shrinking dimensions of interconnects in VLSI and ULSI technology have placed additional demands on processing capabilities. Reliable formation of gate pattern is important to VLSI and ULSI success and to the continued effort to increase circuit density and quality of individual substrates and die.

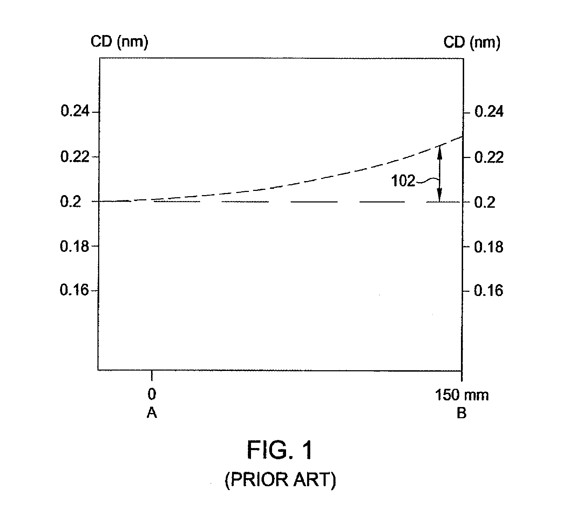

As the feature sizes have become smaller and the aspect ratio of the features become higher, an etching process is being required to etch materials into features having better profile control and uniformity management. During etching, a gas mixture including at least a halogen containing gas is typically used to provide aggressive reactive etchants to etch the materials disposed on a substrate. The halogen containing gases are supplied to the processing chamber through a gas distribution plate disposed in an etching chamber to an upper surface of the substrate. However, during etching, the gas mixture may not be uniformly distributed across the surface of the substrate, thereby resulting in etching profile non-uniformity between the center and edge portion of the substrate. Figure 1 depicts a critical dimension (CD) map of features formed on a substrate from point A of the substrate center to point B of the substrate edge etched by a conventional etching technique. As the reactive etchants generated from the plasma may not be uniformly distributed across the substrate surface, the etching behaviors resulted in the center portion A and edge portion B of the substrate are different, thereby resulting in CD variation and a drift in resultant dimensions of the etched features from its target dimension, as shown by arrow 102. Non-uniform CD profile of the features may result in unwanted defects, and further adversely affect subsequent process steps, ultimately degrading or disabling the performance of the final integrated circuit structure.

Therefore, there is a need for a method of etching features on a substrate with good CD uniformity control.

Embodiments of the present invention pertain to methods for etching a metal layer disposed on a substrate to form features with desired profile and uniform critical dimension (CD) of the features across the substrate. In one embodiment, a method for etching a metal layer disposed on a substrate includes providing the substrate having the metal layer disposed on the substrate in an etch reactor, flowing a gas mixture containing at least a chlorine containing gas and a passivation gas into the reactor, and etching the metal layer using a plasma formed from the gas mixture. The passivation gas includes a nitrogen containing gas and an unsaturated hydrocarbon gas, wherein the nitrogen containing gas and the unsaturated hydrocarbon gas have a gas flow rate ratio between about 1:3 and about 20:1.

In another embodiment, a method for etching a metal layer disposed on a substrate to form an interconnection structure includes providing a substrate having an aluminum layer suitable for an interconnect structure disposed on a substrate in an etch reactor, flowing a gas mixture containing BCl₃, Cl₂ and a passivation gas into the reactor, and etching the aluminum layer through a patterned mask layer using a plasma formed from the gas mixture. The passivation gas includes a nitrogen gas and an unsaturated hydrocarbon gas wherein the nitrogen gas and the unsaturated hydrocarbon gas have a gas flow rate ratio between about 1:3 and about 20:1.

In yet another embodiment, a method for etching a metal layer disposed on a substrate to form an interconnection structure includes providing a substrate having a patterned mask layer on an aluminum layer (suitable for an interconnect structure disposed on a substrate in an etch reactor, flowing a gas mixture containing a BCl₃, Cl₂ gas and a passivation gas into an etch reactor, and etching the aluminum layer through the patterned mask layer using a plasma formed from the gas mixture. The passivation gas includes an N₂ gas and a C₂H₄ gas, wherein a gas flow rate ratio of the N₂ gas and the C₂H₄ gas is between about 1:3 and about 20:1, and wherein the C₂H₄ gas is supplied with a diluent gas into the etch reactor at a molecular ratio of C₂H₄ gas to diluent gas between about 25:75 and about 35:65.

Further advantages, features, aspects and details that can be combined with embodiments described herein are evident from the claims, the description and the drawings.

Embodiments are also directed to a device for carrying out the disclosed methods and including device parts for performing each described method steps. These method steps may be performed by way of hardware components, a computer programmed by appropriate software, by any combination of the two or in any other manner. Furthermore, embodiments are also directed to methods by which the described device operates. It includes method steps for carrying out every function of the device.

So that the manner in which the above recited features of the present invention are attained and can be understood in detail, a more particular description of the invention, briefly summarized above, may be had by reference to the embodiments thereof which are illustrated in the appended drawings.

Figure 1 depicts a critical dimension (CD) map of features formed across a substrate etched by a conventional technique;

Figure 2 is a schematic cross-sectional view of a plasma reactor used according to one embodiment of the invention;

Figure 3 is a flow diagram of one embodiment of an etching process according to one embodiment of the invention;

Figures 4A-4B are sectional views of one embodiment of an interconnect structure disposed on a substrate; and

Figure 5 depicts a critical dimension (CD) map of features formed across a substrate etched by an etching process according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

Embodiments of the present invention include methods for plasma etching a metal layer disposed on a substrate using a gas mixture including at least a chlorine containing gas and a passivation gas, wherein the passivation gas includes at least a nitrogen gas and a unsaturated hydrocarbon gas. The gas mixture etches the metal layer in a manner that preserves profiles and dimensions of features while maintaining a uniform critical dimension (CD) of the features formed across the substrate.

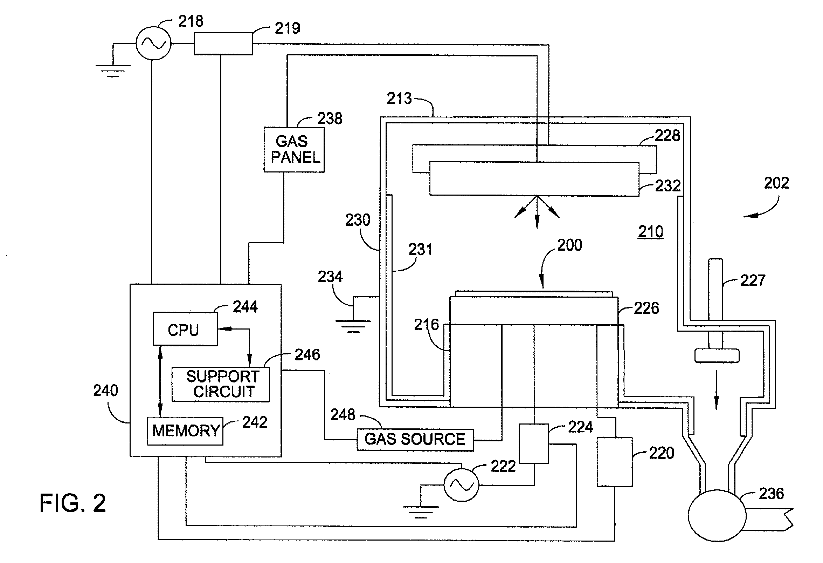

Figure 2 depicts a schematic, cross-sectional diagram of one embodiment of a plasma source etch reactor 202 suitable for performing the metal layer etch according to the present invention. Exemplary etch reactors that are suitable for practicing the invention is Decoupled Plasma Source (DPS), DPS-II, DPS-II AdvantEdge HT, DPS Plus, or DPS DT, HART, a HART TS etch reactor, all available from Applied Materials, Inc., of Santa Clara, California. It is contemplated that the metal layer etching process described herein may be performed in other etch reactors, including those from other manufacturers.

In one embodiment, the reactor 202 includes a process chamber 210. The process chamber 210 is a high vacuum vessel that is coupled through a throttle valve 227 to a vacuum pump 236. The process chamber 210 includes a conductive chamber wall 230. The temperature of the chamber wall 230 is controlled using liquid-containing conduits (not shown) that are located in and/or around the wall 230. The chamber wall 230 is connected to an electrical ground 234. A liner 231 is disposed in the chamber 210 to cover the interior surfaces of the walls 230. The liner 231 facilitates *in-situ* self-cleaning capabilities of the chamber 210, so that byproducts and residues deposited on the liner 231 can be readily removed.

The process chamber 210 also includes a support pedestal 216 and a showerhead 232. The support pedestal 216 is disposed below the showerhead 232 in a spaced-apart relation. The support pedestal 216 may include an electrostatic chuck 226 for retaining a substrate 200 during processing. Power to the electrostatic chuck 226 is controlled by a DC power supply 220.

The support pedestal 216 is coupled to a radio frequency (RF) bias power source 222 through a matching network 224. The bias power source 222 is generally capable of producing a bias power of about 0 to 3,000 Watts. Optionally, the bias power source 222 may be a DC or pulsed DC source.

The temperature of the substrate 200 supported on the support pedestal 216 is at least partially controlled by regulating the temperature of the support pedestal 216. In one embodiment, the support pedestal 216 includes a channels formed therein for flowing a coolant. In addition, a backside gas, such as helium (He) gas, provided from a gas source 248, fits provided into channels disposed between the back side of the substrate 200 and grooves (not shown) formed in the surface of the electrostatic chuck 226. The backside He gas provides efficient heat transfer between the pedestal 216 and the substrate 200. The electrostatic chuck 226 may also include a resistive heater (not shown) within the chuck body to heat the chuck 226 during processing.

The showerhead 232 is mounted to a lid 213 of the processing chamber 210. A gas panel 238 is fluidly coupled to a plenum (not shown) defined between the showerhead 232 and the lid 213. The showerhead 232 includes a plurality of holes to allow gases provided to the plenum from the gas panel 238 to enter the process chamber 210.

The showerhead 232 and/or an upper electrode 228 positioned proximate thereto is coupled to an RF source power 218 through an impedance transformer 219 (e.g., a quarter wavelength matching stub). The RF source power 218 is generally capable of producing a source power of about 0 to 5,000 Watts.

During substrate processing, gas pressure within the interior of the chamber 210 is controlled using the gas panel 238 and the throttle valve 227. In one embodiment, the gas pressure within the interior of the chamber 210 is maintained at about 0.1 to 999 mTorr. The substrate 200 may be maintained at a temperature of between about 10 to about 500 degrees Celsius.

A controller 240, including a central processing unit (CPU) 244, a memory 242, and support circuits 246, is coupled to the various components of the reactor 202 to facilitate control of the processes of the present invention. The memory 242 can be any computer-readable medium, such as random access memory (RAM), read only memory (ROM), floppy disk, hard disk, or any other form of digital storage, local or remote to the reactor 202 or CPU 244. The support circuits 246 are coupled to the CPU 244 for supporting the CPU 244 in a conventional manner. These circuits include cache, power supplies, clock circuits, input/output circuitry and subsystems, and the like. A software routine or a series of program instructions stored in the memory 242, when executed by the CPU 244, causes the reactor 202 to perform an etch process of the present invention.

Figure 2 only shows one exemplary configuration of various types of plasma reactors that can be used to practice the invention. For example, different types of source power and bias power can be coupled into the plasma chamber using different coupling mechanisms. Using both the source power and the bias power allows independent control of a plasma density and a bias voltage of the substrate with respect to the plasma. In some applications, the plasma may be generated in a different chamber from the one in which the substrate is located, e.g., remote plasma source, and the plasma subsequently guided into the chamber using techniques known in the art.

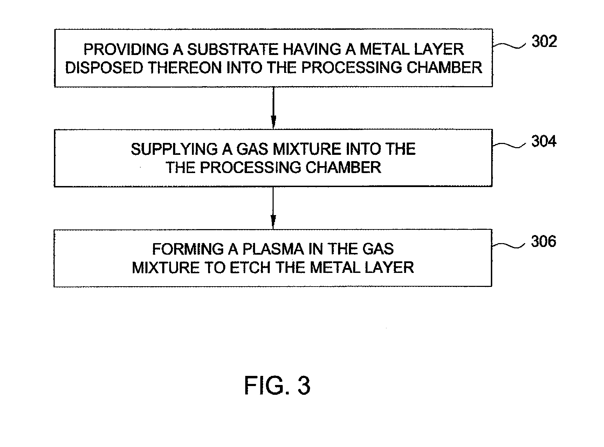

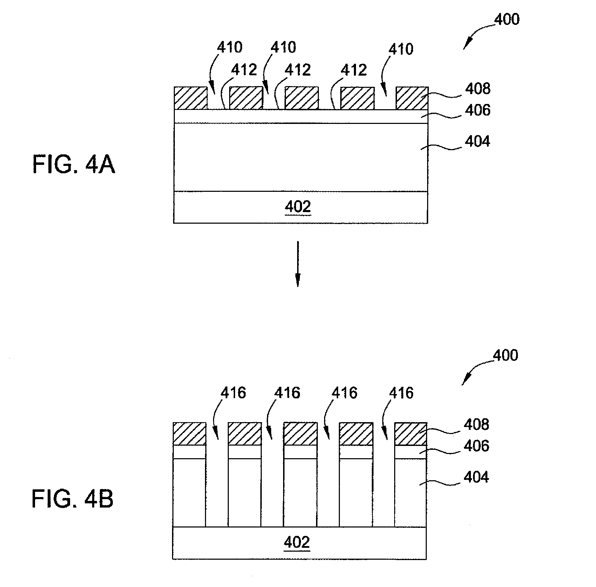

Figure 3 illustrates a flow diagram of one embodiment of an etch process 300 of etching a metal layer according to one embodiment of the invention. Figures 4A-4B are schematic cross-sectional views illustrating the sequence of the metal layer etching process 300. The process 300 may be stored in memory 242 as instructions that executed by the controller 240 to cause the process 300 to be performed in a plasma processing chamber, such as the reactor 202 or other suitable etch reactor.

The process 300 begins at a block 302 by providing a substrate 402 having a film stack 400 containing a metal layer 404 disposed on the substrate 402 in the reactor 202. The film stack 400 may be utilized to form an interconnection structure on the substrate 402. In some embodiments, an optional barrier layer 406 may be disposed on the metal layer 404. A patterned mask layer 408, e.g., a hard mask, photoresist mask, or the combination thereof, may be used as an etch mask defining openings 410 to expose portions 412 of the film stack 400 for etching features therein.

In the embodiment depicted in Figure 4A, the metal layer 404 is an aluminum containing layer. Suitable examples of aluminum containing layer include aluminum metal, aluminum alloy, and the like. In an exemplary embodiment, the metal layer 404 is an aluminum metal (Al) layer. The aluminum metal layer 404 has a thickness of aluminum between about 1000 Å and about 20000 Å, such as about 3000 Å and about 7000 Å, for example, about 4000 Å. The optional barrier layer 406 disposed on the metal layer 404 is used to prevent the underlying metal layer 404 from diffusing into the adjacent layers. Suitable examples of the barrier layer 406 may be tantalum (Ta), tantalum nitride (TaN), tantalum silicon nitride (TaSiN), titanium nitride (TiN), and titanium (Ti) or combinations thereof. The patterned mask layer 408 may be in the form of a single layer selected from a group consisting of silicon oxide, silicon nitride, silicon oxynitride (SiON), amorphous silicon (α-Si) or silicon carbide, amorphous carbon (α-carbon), among other silicon films. Alternatively, the patterned mask layer 408 may be in form of a composite mask including at least two layers, one of which selected from the materials described above and the second of which comprising an organic photoresist layer. In the embodiment wherein the optional barrier layer 406 is not present, the patterned mask layer 408 may be directly disposed on the metal layer 404. In an exemplary embodiment, the patterned mask layer 408 is a silicon oxynitride (SiON) layer. In one embodiment, the film stack 400 is suitable for fabricating an interconnection structure in a back end line (BEOL).

At block 304, a metal layer etching gas mixture is supplied into the reactor 202 for etching the metal layer 404 through the openings 410 defined by the patterned mask layer 408. The metal layer etching gas mixture etches the metal layer 404 to form features 416 in the material layer 404, as shown in Figure 4B. In the embodiment wherein the optional barrier layer 406 is present, the optional barrier layer 406 may be etched using the same gas mixture supplied at block 304 to etch the metal layer 404. Alternatively, the optional barrier layer 406 may be etched by a barrier layer etching gas mixture which is different from the metal layer etching gas mixture and selectively etches the optional barrier layer 406 over the metal layer 404. In one embodiment, the optional barrier layer 406 and the metal layer 404 may be etched in a single chamber using different gas mixtures supplied during different periods of the etch process. In an exemplary embodiment, the optional barrier layer 406 may be etched by a barrier layer etching gas mixture that includes at least a halogen containing gas.

In one embodiment, the metal layer etching gas mixture supplied at block 304 includes a chlorine containing gas. The chlorine containing gas is used to provide reactive etchants for etching the metal layer 404. Suitable examples of the chlorine containing gas include at least one of BCl₃, Cl₂, or HCl. In one embodiment, the chlorine containing gas is supplied in the gas mixture at a rate between about 20 sccm and about 800 sccm. In a particular embodiment described herein, the chlorine containing gas that is used to etch the metal layer 404 includes BCl₃ and Cl₂ gas. BCl₃ gas is supplied at a rate of between about 20 sccm and 400 sccm and Cl₂ gas is supplied at a rate of between about 10 sccm and 800 sccm.

Furthermore, a passivation gas is supplied in the gas mixture to passivate a portion of the etched features 416, e.g, sidewalls of the etched features, during the etching process to maintain vertical profiles in the metal layer 404 being etched until the desired depth of the features are formed in the metal layer 404. In one embodiment, the passivation gas includes a nitrogen containing gas and an unsaturated hydrocarbon gas. Suitable examples of nitrogen containing gas include N₂, NH₃, and the like. Suitable examples of the unsaturated hydrocarbon gas include any carbon and hydrogen based polymers that contain a monomer of - C=C - or - C=C -, such as C₂H₄, C₃H₆, C₄H₈, and the like. In an exemplary embodiment, the passivation gas includes at least a N₂ gas and a C₂H₄ gas.

In one embodiment, the N₂ gas provides passivation species during the etching process. The passivation species react with the dissociated chlorine ions in the gas mixture during metal etching process and form metal nitride on the surfaces and sidewalls of the etched feature. The formed metal nitride deposited on the surfaces and sidewalls of the etched features passivates the etched features in a manner that controls the vertical profile and critical dimension of the features formed in the metal layer 404.

Furthermore, the unsaturated hydrocarbon gas supplied in the gas mixture also form polymers during the etching process, passivating sidewalls and surfaces of the etched features, thereby providing a good vertical profile of the features formed in the metal layer 404. In one embodiment, the unsaturated hydrocarbon gas is supplied in the gas mixture with a chemically inactive gas. In the embodiment wherein the unsaturated hydrocarbon gas is C₂H₄ gas, the C₂H₄ is diluted with helium (He) gas. The molecular ratio of C₂H₄ to He is between about 25 percent (%) and about 35 percent (%) in the total gas flow of C₂H₄ and He diluent gas. For example, C₂H₄ is diluted with He gas having a ratio of C₂H₄ to He about 30 present to 70 percent (C₂H₄:He) for a dilution factor of about 2.33. In conventional techniques, a low molecular ratio of C₂H₄ diluted in He gas, such as C₂H₄:He of 2.7 percent : 97.3 percent, is suggested to prevent excess amount of C₂H₄ gas for safety reasons since pure C₂H₄ tends to be explosive and flammable. Additionally, it is believed in conventional techniques that higher amount of diluted flow is desirable to provide a wide process window and to enable achieving nearly vertical etching profile. However, the inventors have discovered that an overly high flow of diluted flow creates high flow turbulence in the plasma, resulting in gas flow fluctuation and plasma instability. In the embodiment wherein the metal intended to be etched is aluminum (Al), the inventors have discovered that the helium ions from the diluted flow tends to creates large numbers of secondary electrons while striking the surface of the aluminum material layer. As the aluminum material has a higher secondary emission coefficient than other materials, such as silicon, photoresist, or silicon oxide, while struck by the secondary electrons from the helium ions, the aluminum surface tends to interact with the secondary electrons from the helium ions, thereby influencing the plasma intensity generated in the gas mixture. The interaction between the helium ions and the aluminum surface may influence in overall ion densities and distribution across in the processing reactor, thereby resulting in gas flow fluctuation and plasma instability. Accordingly, a high molecular ratio of C₂H₄ diluted in He gas, greater than 25 percent of C₂H₄ gas in total gas flow of C₂H₄ and He diluent, along with a desired gas flow ratio of N₂ gas to the total gas mixture results a good control of the etching and passivating behaviors in the metal layer etching process. A higher amount of C₂H₄ gas in total gas flow of C₂H₄ and He diluent may also provide higher concentration of passivation species in the gas mixture which increases the passivation protection formed on the substrate surface.

Additionally, the higher concentration of the C₂H₄ gas in the diluent gas may also impact on the pressure maintained in the processing chamber during etching. Higher processing pressure during etching may provide higher chances of molecular collision, thereby assisting the overall etching reaction. Accordingly, by controlling the processing pressure at a relatively higher range, such as greater than 10 milliTorr, along with the high concentration of the C₂H₄ gas, a higher chance of molecular collision is obtained, thereby resulting in higher concentration of passivation species in the gas mixture and increasing the passivation protection formed on the substrate surface. In an exemplary embodiment, the value that the molecular ratio of C₂H₄ in the diluent gas times the processing chamber pressure (in millliTorr) is controlled at about greater than 1.25 to achieve a desired amount of passivation species during etching. For example, in the embodiment wherein the molecular ratio of C₂H₄ to the diluent gas is 25% (0.25) and the chamber pressure is controlled at 15 mTorr, molecular ratio of 0.25 times the chamber pressure 15 equals to 3.75 (0.25 x 15 = 3.75), which is greater than 1.25. In another embodiment, the value of the molecular ratio of C₂H₄ to diluent times the processing chamber pressure is controlled at greater than 1.25, such as greater than 1.5, for example, greater than 2.

Furthermore, the secondary electrons from He diluent also seem to interact with the chlorine ions from the chlorine containing gas supplied in the gas mixture. Accordingly, by controlling the amount of chlorine containing gas supplied in the gas mixture, a sufficient amount of chlorine ions released from the chlorine containing gas may be utilized to reduce the turbulence caused by the He diluent secondary electron. As the secondary electron from the He diluent may efficiently interact with the chlorine to reduce the overall amount of secondary electrons remaining in the gas mixture, the plasma instability and gas flow fluctuation caused by the He diluent secondary electrons is efficiently reduced. In one embodiment, the amount of chlorine containing gas supplied in the gas mixture may be controlled to have substantially equal amount of He diluent gas supplied into the etch reactor. For example, the flow rate of the chlorine containing gas may be supplied at a substantially equal rate of He diluent gas supplied into the etch reactor. In the embodiment wherein the chlorine containing gas include both BCl₃ and Cl₂ gases, the Cl₂ gas supplied in the gas mixture may be controlled at a substantially equal rate of He diluent gas supplied into the etch reactor. In this particular embodiment, the Cl₂ gas is supplied at a flow rate between about 100 sccm and about 300 sccm, such as between about 125 sccm and about 250 sccm.

During etching, different regions across the substrate 402, e.g., center or edge of the substrate 402, may receive different amounts of the gas mixture supplied from the showerhead 232, resulting in variation in the etch rate in the different regions of the substrate 402. For example, as reactive species provided in the gas mixture, such as the reactive etchants from the chlorine containing gas and the passivate species from the nitrogen and unsaturated hydrocarbon gas, may have different atomic mass and mean flow path, the flow rate/speed for each gas species traveling toward the edge of the substrate may be different, the resulting ratio of gas species in different regions of the substrate 402 may vary. For example, nitrogen gas has a faster and more uniform flow rate across the substrate surface than an unsaturated hydrocarbon gas. As for the unsaturated hydrocarbon gas supplied in the gas mixture, upon plasma dissociation, the unsaturated hydrocarbon species tends to form long polymer chains from substrate center across the substrate surface to the substrate edge, resulting in larger amounts and longer chains of unsaturated hydrocarbon species accumulated along the substrate edge than near the substrate center. This effect prevails over the process parameters of higher concentration of the unsaturated hydrocarbon gas, such as C₂H₄ gas, and the higher process pressure controlled during the etching process. The larger amount of passivation species accumulated on the substrate surface provides high passivation protection but lower etching rates, thus, resulting in etched features having a wider actual critical dimension (CD) than target critical dimension (CD), which is known as CD gain, in the substrate surface. In contrast, in regions of the substrate where smaller amounts of passivation species are accumulated and larger amounts of reactive etchants are generated, a narrow critical dimension (CD), which is known as CD loss, may be found on the substrate surface. Therefore, by adjusting the flow amount and flow ratio between the nitrogen gas, unsaturated hydrocarbon gas, and molecular concentration of the unsaturated hydrocarbon gas contained in the diluent gas supplying in the gas mixture, the mobility of each gas specie supplied in the gas mixture may be relatively adjusted. Accordingly, a desired ratio between the passivation species and reactive etchants may be obtained, providing a good control of passivation protection and etching behavior, thereby forming features with desired profile and dimension across the width of the metal layer 404. Therefore, an adjusted and balanced amount of passivation species distributed across the substrate surface may be obtained, thereby providing a uniform critical dimension (CD) of the etched features 416 formed within the material layer 404 on the substrate.

In the embodiment wherein the substrate edge requires less passivation protection but requires higher reactive species for etching, a low flow rate ratio of C₂H₄ gas to N₂ gas, such as a lower amount of C₂H₄ gas relative to a higher amount of N₂ gas, may be used to reduce the presence of long chain carbon-carbon polymers formed near the edge of the substrate, thereby promoting substrate edge etching rate. In contrast, in the embodiment wherein the substrate edge requires higher passivation protection but requires lower reactive species for etching, a higher flow rate ratio of C₂H₄ gas to N₂ gas, such as a higher amount of C₂H₄ gas relative to a lower amount of N₂ gas, may be used to increase the amount of long chain carbon-carbon polymers formed near the edge of the substrate.

In one embodiment, the flow rate ratio between the N₂ gas to the C₂H₄ gas (with a molecular concentration of 30% in diluent gas) is between about 1:3 and about 20:1. In another embodiment, the flow rate ratio between the N₂ to the C₂H₄ gas is between about 1:1 and about 10:1, such as 3:1. In yet another embodiment, the N₂ and the C₂H₄ gas (with a concentration of 30% in diluent gas) supplied in the gas mixture is configured to be substantially equal amount, such as having a flow rate ratio of N₂ and the C₂H₄ (with a concentration of 30% in diluent gas) of 1:1. Alternatively, the N₂ gas is supplied in the gas mixture at a rate between about 1 sccm and about 500 sccm, such as between about 1 sccm and about 30 sccm. The C₂H₄ gas (with a concentration of 30% in diluent gas) is supplied at a rate between about 1 sccm and about 100 sccm, such as between about 1 sccm and about 30 sccm. Optionally, the gas mixture may further include an inert gas. Suitable examples of the inert gas include Ar, He, Xe, Kr and the like.

At block 306, a plasma is formed from the gas mixture to etch the metal layer 404 to a desired profile and uniform critical dimension (CD) on the etched features 416. The plasma dissociates the gas mixture, forming reactive etchants and passivation species in the gas mixture, thereby etching and passivating the metal layer 404 in a manner that provides uniform critical dimension (CD) of the features 416 formed in the metal layer 404.

Several process parameters are regulated while the metal layer etch gas mixture is supplied into the etch reactor 202. In one embodiment, a pressure of the gas mixture in the etch reactor is regulated between about 5 mTorr to about 200 mTorr, for example, between about 10 mTorr to about 30 mTorr. The substrate temperature is maintained between about 10 degrees Celsius and about 90 degrees Celsius, for example, between about 30 degrees Celsius and about 60 degrees Celsius. The RF source power may be applied at a power of about 400 Watts to about 3000 Watts, such as about 1200 Watts, to provide a plasma from the gas mixture. The carrier gas, such as Ar or He, may be provided at a flow rate between about 0 sccm to about 200 sccm, for example about 5 sccm to about 40 sccm. The etching time may be processed at between about 60 seconds to about 400 seconds. The process of etching the metal layer 404 is terminated after reaching an endpoint signaling that the underlying substrate 402 has been exposed. The endpoint may be determined by any suitable method. For example, the endpoint may be determined by monitoring optical emissions, expiration of a predefined time period or by another indicator for determining that the dielectric barrier layer 406 to be etched has been sufficiently removed.

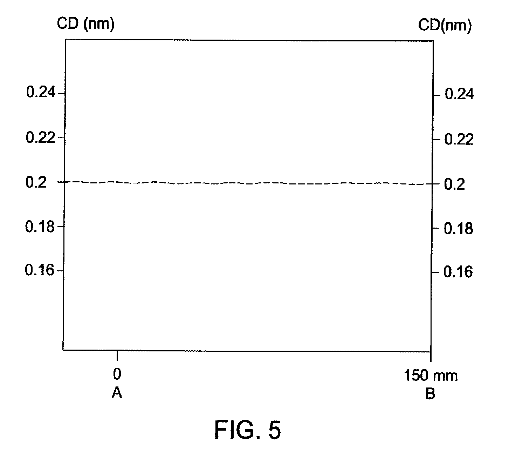

Figure 5 depicts a critical dimension (CD) map of features 416 formed on the substrate 402 from point A at the substrate center to point B at the substrate edge etched by the selected flow rate ratio between the nitrogen and unsaturated hydrocarbon gas supplied in the gas mixture described at block 304. With a well selected flow rate ratio between the nitrogen gas and the unsaturated hydrocarbon gas, a uniform critical dimension (CD) across the substrate surface may be obtained, thereby preserving a desired and uniform profile of the etched features across the substrate surface.

In a further embodiment, a method for etching a material layer disposed on a substrate includes providing a substrate having a metal layer disposed on a substrate into an etch reactor, flowing a gas mixture containing at least a chlorine containing gas and a passivation gas into the reactor, the passivation gas including a nitrogen gas and an unsaturated hydrocarbon gas, wherein the nitrogen gas and the unsaturated hydrocarbon gas have a gas flow rate ratio between about 1:3 and about 20:1, and etching the metal layer using a plasma formed from the gas mixture.

Embodiments of the present invention provide an improved method for etching a metal layer in an interconnection structure. The method advantageously preserves the profile and dimension of features formed in the interconnection structure by selecting a desired ratio of passivation gases for etching, thereby efficiently adjusting the resultant critical dimension of the features formed within the metal layer.

While the foregoing is directed to embodiments of the present invention, other and further embodiments of the invention may be devised without departing from the basic scope thereof, and the scope thereof is determined by the claims that follow.

## Claims

1. A method for etching a metal layer (404) disposed on a substrate (200, 402) to form an interconnection structure, comprising:
providing the substrate having the metal layer disposed on the substrate in an etch reactor (202);
flowing a gas mixture containing at least a chlorine containing gas and a passivation gas into the reactor, the passivation gas including a nitrogen containing gas and an unsaturated hydrocarbon gas, wherein the nitrogen containing gas and the unsaturated hydrocarbon gas have a gas flow rate ratio between about 1:3 and about 20:1; and
etching the metal layer using a plasma formed from the gas mixture.

2. The method of claim 1, wherein the etching further comprises:
etching the metal layer through openings defined by a patterned mask layer (408).

3. The method of claim 2, wherein the mask layer is at least one of silicon oxide, silicon nitride, silicon oxynitride (SiON), amorphous silicon (α-Si), silicon carbide and amorphous carbon (α-carbon).

4. The method of any of the previous claims, wherein the metal layer is an aluminum containing layer.

5. The method of any of the previous claims, wherein the flowing of the gas mixture further comprises:
flowing Cl₂ gas at a rate between about 10 sccm and about 800 sccm; and
flowing BCl₃ gas at a rate between about 20 sccm and about 400 sccm.

6. The method of any of the previous claims, wherein the nitrogen containing gas is N₂ and the unsaturated hydrocarbon gas is C₂H₄.

7. The method of any of the previous claims, wherein the unsaturated hydrocarbon gas is supplied with a diluent gas to the etch reactor.

8. The method of claim 7, wherein the diluent gas is He.

9. The method of any of the claims 7 to 8, wherein the unsaturated hydrocarbon gas and the diluent gas are supplied into the etch reactor at a molecular ratio of unsaturated hydrocarbon gas to diluent gas between about 25:75 and about 35:65.

10. The method of any of the claims 1 to 9, further comprising:
maintaining a pressure of the etch reactor at between about 5 mTorr and about 200 mTorr.

11. The method of claim 10, wherein a value of the molecular ratio of the unsaturated hydrocarbon gas in the diluent gas times the reactor pressure is greater than about 1.25.

12. The method of any of the claims 7 to 11, wherein the diluent gas is supplied at a flow rate substantially equal to a flow rate of the chlorine containing gas.

13. The method of any of the claims 2 to 12, wherein a barrier layer (406) is disposed between the metal layer and the patterned mask layer.

14. A method for etching a metal layer (404) disposed on a substrate (200, 402), comprising:
providing the substrate having an aluminum layer suitable for an interconnect structure disposed on the substrate in an etch reactor (202);
flowing a gas mixture containing BCl₃, Cl₂ and a passivation gas into the reactor, the passivation gas including a nitrogen gas and an unsaturated hydrocarbon gas, wherein the nitrogen gas and the unsaturated hydrocarbon gas have a gas flow ratio between about 1:3 and about 20:1; and
etching the aluminum layer through a patterned mask layer (408) using a plasma formed from the gas mixture.

15. The method of claim 14, wherein flowing the gas mixture further comprises:
adjusting the flow rate ratio between the nitrogen gas and the unsaturated hydrocarbon gas to adjust critical dimension of features (416) formed in the aluminum layer.
